Europäisches Patentamt

(19) European Patent Office

Office européen des brevets

(11) Publication number: **0 017 228**
**B1**

(12) **EUROPEAN PATENT SPECIFICATION**

(45) Date of publication of patent specification: **11.07.84**

(51) Int. Cl.³: **G 11 C 11/24,** G 11 C 8/00

(21) Application number: **80101776.5**

(22) Date of filing: **03.04.80**

(54) **Memory device.**

(30) Priority: **04.04.79 JP 40671/79**

(43) Date of publication of application:
**15.10.80 Bulletin 80/21**

(45) Publication of the grant of the patent:
**11.07.84 Bulletin 84/28**

(84) Designated Contracting States:
**DE FR GB NL**

(56) References cited:
GB - A - 2 024 474
US - A - 3 962 686
US - A - 3 964 030
US - A - 3 969 706
US - A - 4 038 646
US - A - 4 072 932
US - A - 4 087 704
US - A - 4 090 096
US - A - 4 104 733

THE SEMICONDUCTOR MEMORY BOOK, Intel,
Wiley Editor, 1978, pages 139-181 New York,
U.S.A. FIELLAND: "Dynamic RAM's used with
Microprocessors"

(73) Proprietor: NEC CORPORATION
33-1, Shiba 5-chome, Minato-ku
Tokyo 108 (JP)

(72) Inventor: Nagami, Akira
c/o Nippon Electric Co., Ltd. 33-1, Shiba Gochome
Minato-ku Tokyo (JP)

(74) Representative: Glawe, Delfs, Moll & Partner
Patentanwälte
Postfach 26 01 62 Liebherrstrasse 20
D-8000 München 26 (DE)

(56) References cited:
ELECTRONICS, vol. 50, no. 9, 28th April 1977,
pages 115-119 New York, U.S.A. COKER: "16-K
RAM Eases Memory Design for Mainframes &
Microcomputers"
ELECTRONICS; VOL: 52, NO: 4, 15TH February
1979, pages 141-147 New York US FORD et al.:
"64-K dynamic RAM has pin that refreshes"
THE SEMICONDUCTOR MEMORY BOOK, Intel,
Wiley Editor, 1978, pages 130-138 New York
US COE: "Designing with 16K Dynamic RAM's"
ELECTRONICS, vol. 49, no. 10, 13th May 1976,
pages 81-86 New York US KUO et al.: "16K
RAM built with proven process may offer high
start-up reliability"

Courier Press, Leamington Spa, England.

ELECTRONIC DESIGN, vol. 27, no. 13, 21th June
1979, pages 58-64 New York US YOUNG:"64-k
RAM with single supply could be the standard
for future desig n"

## Description

The invention relates generally to a memory device comprising a plurality of memory cells arranged at intersections of word lines and digit lines. The invention is particularly applicable to a memory device employing insulated gate field effect transistors (IGFET's) on a semiconductor chip.

In dynamic random access memories employing IGFET's (hereinafter abbreviated as dynamic RAM) a 2-clock multi-address system has been employed in a 16 K-bit memory as well as a 64 K-bit memory both with a 16-pin package structure. The details of this multi-address system is disclosed in the specification and drawings of U.S. Patent 3,969,706 issued to Robert J. Proebsting et al on July 13, 1976. Basically, two input clocks, that is, a row strobe signal defined as ROW ADDRESS STROBE (abbreviated as $\overline{RAS}$) and a column strobe signal defined as COLUMN ADDRESS STROBE (abbreviated as $\overline{CAS}$) are generated in a predetermined sequence. In the following description, an example is adopted where N-channel IGFET's are used and $\overline{RAS}$ and $\overline{CAS}$ are assumed to be active when they are low signals. At first, when $\overline{RAS}$ becomes active by turning it from a high level to a low level, input levels at address terminals at that time point are incorporated in the memory and held therein as row address inputs which are used to select a word line and refresh memory cells connected to the selected word line. After completion of latching of address inputs of response to $\overline{RAS}$, $\overline{CAS}$ becomes active by being turned from a high level to a low level thereby to incorporate the input levels at the address terminals at this time in the memory as column address inputs. Depending upon a level of a write control signal defined as WRITE ENABLE (abbreviated as $\overline{WE}$), if $\overline{WE}$ is not in its active level, i.e., remains high, then data read-out from the selected memory cell is effected so that the data appear at a data output terminal. While if WE is in the active level then the data at a data input terminal at the time point is written in the selected memory cell.

Recently, a refresh operation called as "HIDDEN REFRESH" has become employed in the multi-address system. This operation is as follows:

After read-out data from a selected memory cell has been obtained by sequentially making $\overline{RAS}$ and $\overline{CAS}$ active the refresh operations for the memory cells on the different word lines can be sequentially effected with maintaining the read-out data at the data output terminal by repeatedly making $\overline{RAS}$ active and maintaining $\overline{CAS}$ at the low level. In other words, during the period when the read-out data is effectively revealed, the refresh operation can be effected simultaneously, and in that means this operation is called HIDDEN REFRESH. However, HIDDEN REFRESH must be performed under such condition that $\overline{WE}$ is maintained at the high level i.e. inactive level, and hence this mode of operation lacks flexibility in control.

An article by FORD et al. in "Electronics", Vol. 52, No. 4, February 15, 1979 describes a 64-K dynamic RAM having various refresh modes. One is a RAS-only refresh, which can be effected irrespective of data-in and write signals, but only with $\overline{CAS}$ inactive, thereby clearing data output. Other modes are internally timed "Automatic Refresh" and "Self-refresh" cycles, which can be effected irrespective of $\overline{CAS}$, data-in and write signals and with the possibility of maintaining previous read-out data, but these cycles require an additional refresh control signal supplied to a separate REFRESH input. Finally, a so-called HIDDEN-REFRESH cycle may be integrated into selected ones of CPU cycles, again controlled by the additional REFRESH signal, but this requires $\overline{RAS}$ and $\overline{CAS}$ as well as write signals to be absent during the refresh cycle. None of these refresh modes is thus comparable with true HIDDEN-REFRESH as hereinbefore defined.

The invention starts from a memory device as known from US-Patent 3 969 706 with an added possibility of HIDDEN-REFRESH, and such a device as defined in the precharacterizing portion of claim 1.

It is an object of the invention to provide a memory device of this kind where the HIDDEN-REFRESH, during which the data read-out may be maintained, can be controlled only by $\overline{RAS}$ and $\overline{CAS}$ irrespective of other inputs such as write or write enable ($\overline{WE}$) signals, and to provide a practical and useful structure for a device realizing this feature.

For solving the object, the invention provides a memory device of the aforementioned kind provided with suppress means for suppressing said control signal when said row strobe signal is once reset within a set period of said column strobe signal and maintain such suppression within the set period of said column strobe signal and said digit control means is inhibited from repeating its operation after deriving the read-out data during said refresh function.

Further improvements of this memory device are defined in the dependent claims.

The memory device according to the invention thus operates according to the following function:

After necessary operations for a selected memory cell have been completed by sequentially making $\overline{RAS}$ and $\overline{CAS}$ active, $\overline{RAS}$ is made inactive while $\overline{CAS}$ is kept active. Then, after a necessary inactive period of $\overline{RAS}$, when $\overline{RAS}$ is again made active, all the active operations based on active level of $\overline{CAS}$ are inhibited, whereby the state at the time point when the necessary operations were completed can be in itself maintained at the data output terminal.

Thus an effective HIDDEN-REFRESH can be performed controlled by $\overline{RAS}$ and $\overline{CAS}$ only

without requiring, or being sensitive to, any further inputs such as $\overline{WE}$, REFRESH control, etc.

Brief description of the drawings:

Fig. 1 is a timing diagram showing a read cycle and a write cycle of a RAM according to the 2-clock system;

Fig. 2 is a timing diagram representing a known page mode cycle;

Fig. 3 is a timing diagram showing known RAS ONLY REFRESH mode;

Fig. 4 is a timing diagram showing known HIDDEN REFRESH mode;

Fig. 5 is a block diagram of a RAM according to the 2-clock system in the prior art;

Fig. 6 is a schematic circuit diagram showing a general timing signal generator circuit of Fig. 5;

Fig. 7 is a timing waveform diagram showing timing signals appearing in Fig. 5;

Fig. 8 is a circuit diagram of an output control circuiting in the circuit shown in Fig. 6;

Fig. 9 is a timing waveform diagram for the circuit according to the present invention;

Fig. 10 is a timing diagram showing an inputoutput timing relationship in HIDDEN REFRESH in the circuit system according to the present invention;

Fig. 11 is a circuit diagram of a basic circuit according to the present invention;

Fig. 12 is an operation waveform diagram for the circuit shown in Fig. 11;

Fig. 13 is a diagram for explaining the fact that the circuit according to the present invention is effective for any combination of timings of RAS and CAS;

Fig. 14 is a circuit diagram showing a practical circuit embodying the present invention; and

Fig. 15 is an operation waveform diagram for the circuit shown in Fig. 14.

In the following description, MOS transistors (hereinafter abbreviated as MOST) which are representative ones among IGFETs are employed, and it is further assumed that MOSTs used herein are N-channel ones wherein a higher level is a logic-1 level, and a lower level is a logic-0 level. However, this invention is not limited to the use of MOSTs and N-channel IGFETs.

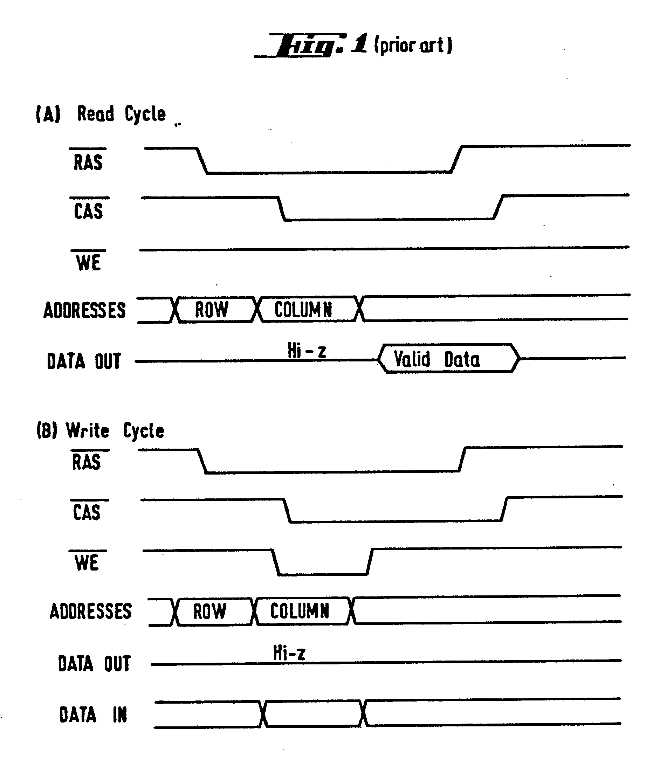

Operations of the known 2-clock multi-address system will be described in greater detail with reference to Figs. 1 to 4.

Timing relations between $\overline{RAS}$, $\overline{CAS}$, $\overline{WE}$, data input and address input in a read cycle and in a write cycle are illustrated in Fig. 1(A) and Fig. 1(B) together with a general waveform of the data output. In the read cycle of Fig. 1(A), after a necessary access time has elapsed from a change of $\overline{CAS}$ to a low level, the effective data appear at the data output and are maintained until $\overline{CAS}$ is changed to a high level to be reset. While in the write cycle of Fig. 1(B), it is a general output mode that the data output terminal is kept at a high impedance state (Hi-Z) and there appear no data.

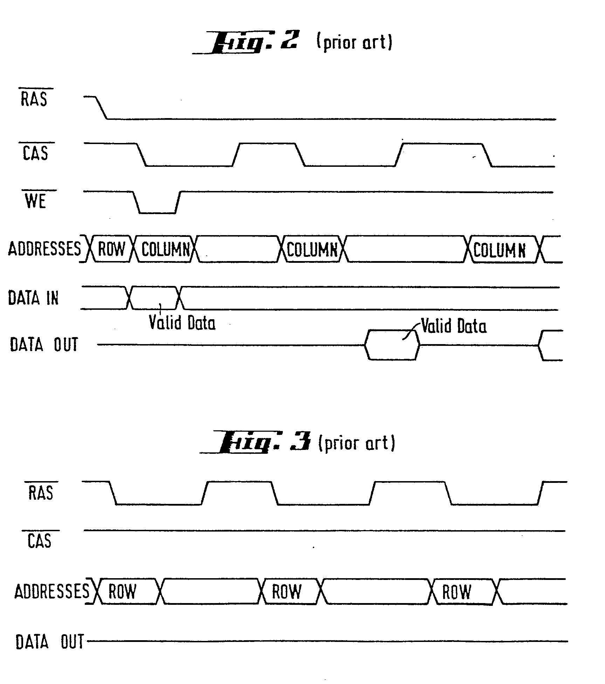

Now description will be made on a so-called "page mode" with reference to Fig. 2. In this mode, $\overline{RAS}$ and $\overline{CAS}$ are changed to a low level to be enabled or activated in sequence, and reset state and enabled state of $\overline{CAS}$ are repeated while maintaining $\overline{RAS}$ at a low level. At a result, with respect to the memory cells on the same word line selected by the operation based on $\overline{RAS}$, write-in or read-out can be achieved in the memory cell at the column address designated by the address input in response to $\overline{CAS}$ only. In other words, if the operation is limited to memory cells on a single word line, it is possible to shorten a cycle time and an access time, and this operation is called "page mode".

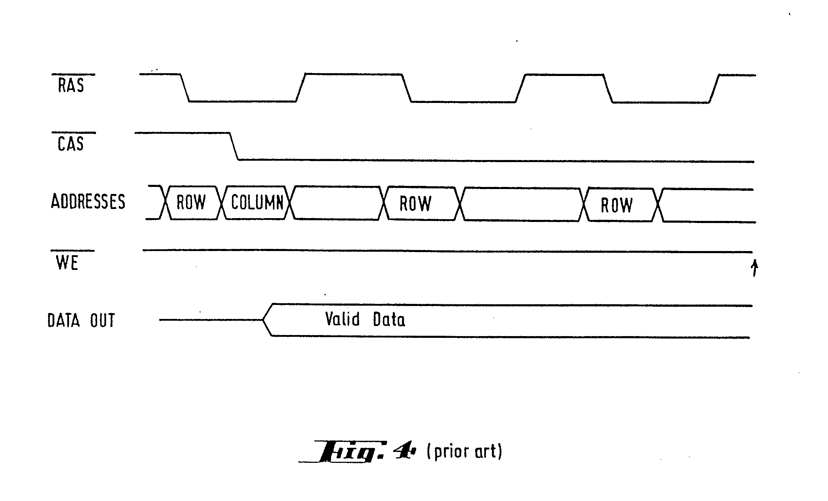

Next the operation of "$\overline{RAS}$ ONLY REFRESH ($\overline{RAS}$ ONLY REFRESH)" will be explained with reference to Fig. 3. $\overline{RAS}$ are repeatedly made a low level and a high level while maintaining $\overline{CAS}$ at a high level, i.e., at its reset state. Then naturally only the circuit portion enabled by $\overline{RAS}$ operates, and the contents of the memory cells on the word line corresponding to the row address designated by the address input are refreshed. This operation is called "RAS ONLY REFRESH".

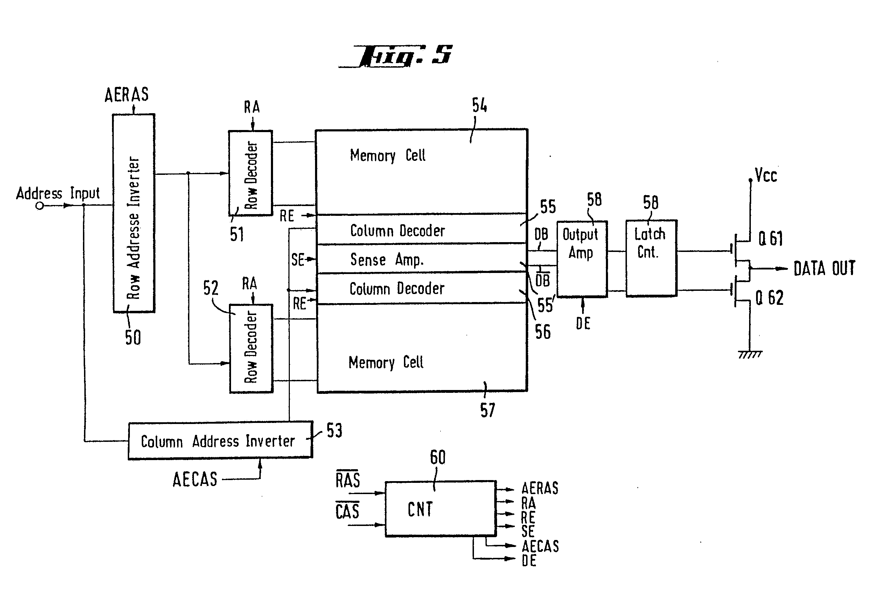

In addition to the normal read cycle and write cycle, the page mode operation and the RAS ONLY REFRESH operation form the characteristic operation of the RAM of 2-clock multi-address system, and still further, an operation illustrated in Fig. 4 has been employed recently.

After read-out data from a selected memory cell has been obtained by sequentially making $\overline{RAS}$ and $\overline{CAS}$ a low level, if $\overline{RAS}$ are repeatedly made a high level and a low level while maintaining $\overline{CAS}$ at the low level, i.e., at its active or enabled state, then while the read-out data are maintained at the data output terminal the contents of the memory cells on the word line designated by the address input can be refreshed. In other words, during the period when the read-out data effectively reveal themselves, refresh can be effected simultaneously, and in that means this operation is called "HIDDEN REFRESH". Heretofore, a restriction was imposed that as shown in Fig. 4, in the HIDDEN REFRESH cycle the input $\overline{WE}$ must be maintained at the high level i.e. its inactive level, and hence this mode of operation lacks versatility as compared to the fact that in the RAS ONLY REFRESH shown in Fig. 3 no restriction is imposed upon the input $\overline{WE}$.

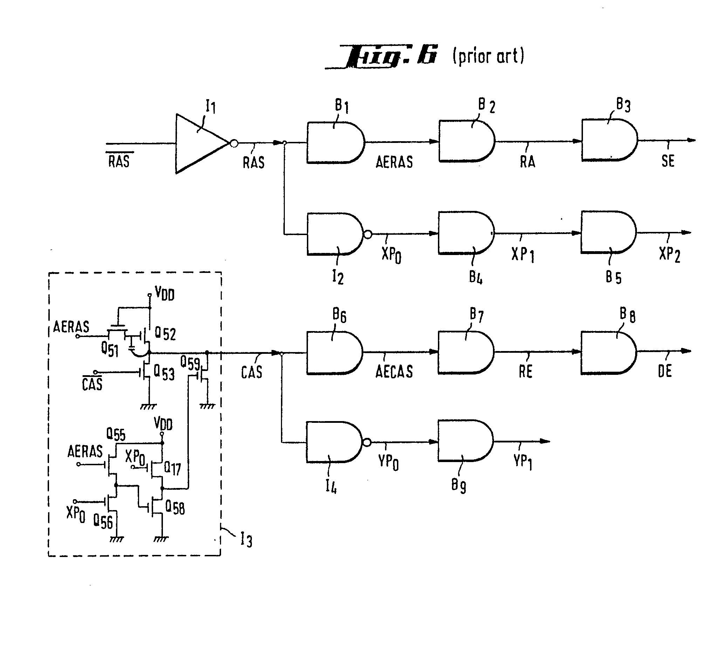

Now, before making a more detailed explanation of the present invention in connection to its preferred embodiment, we will first explain a general circuit system of a RAM according to the 2-clock multi-address system in the prior art with reference to Fig. 5. The RAM shown in Fig. 5 comprises a row address inverter 50, row decoders 51 and 52, a column address inverter 53, memory cell arrays 54 and 57, column decoders 55 and 56, a sense amplifier 55', an output amplifier 58, a latch control circuit 59 and a control timing generator circuit 60 responsive to $\overline{RAS}$ and $\overline{CAS}$.

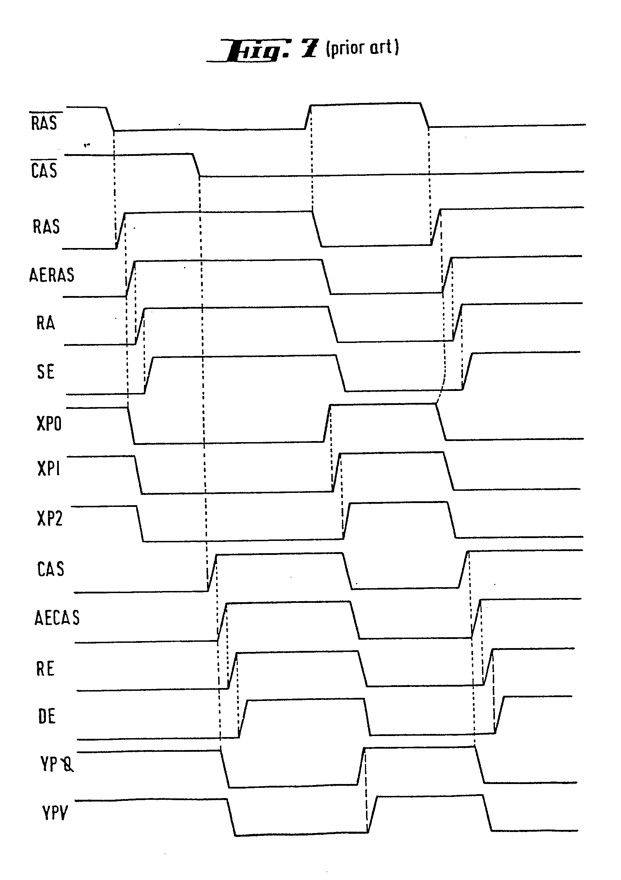

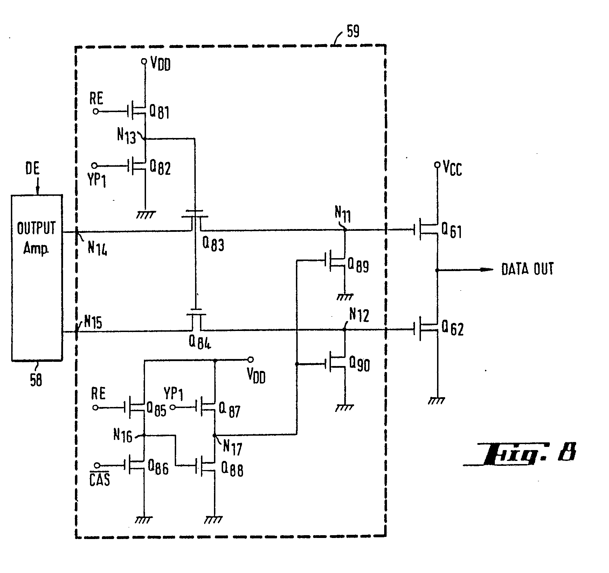

The structure of the control timing generator circuit 60 is disclosed in Fig. 6. The respective timing signal waveforms generated via inverters $I_1$ to $I_4$ and buffers $B_1$ to $B_9$ in Fig. 6 are shown in Fig. 7. When $\overline{RAS}$ shifts from the high level to the low level and thus it goes into an active period, a level-inverted output RAS derived from the inverter $I_1$ rises at first. In response to the rise of RAS, precharge timing signals $XP_0$, $XP_1$ and $XP_2$ are successively changed to the low level. Also a timing signal AERAS rises, so that the output of the row address inverter 50 can respond to the address input. After a selection/non-selection operation in the row decoders 51 and 52 has been completed, a timing signal RA rises, and hence the selected word line rises in level. In response to the signal RA, a timing signal SE rises, so that the sense amplifier 55' is enabled. Thus the contents in the memory cells 54 and 57 on the selected word line are refreshed. Then, circuit operations in response to $\overline{RAS}$ have been finished.

On the other hand, a gate of MOST $Q_{52}$ forming the load of the inverter $I_3$ to which $\overline{CAS}$ is applied, is charged in response to AERAS derived from $\overline{RAS}$. If this charging has been completed and also CAS shifts from the high level to the low level to achieve its active state, then a level-inverted output CAS rises. In response to CAS, precharging timing signals $YP_0$ and $YP_1$ fall in level and a timing signal AECAS rises, so that the output of the column address inverter 53 responds to the address input. After completion of a selection/non-selection operation of the column decoder 56, a timing signal RE rises and hence the digit line of the selected column is connected to a data input/output line. In response to the timing signal RE, a timing signal DE rises in level, so that the output amplifier 58 is enabled, hence the information in the selected memory cell that has appeared on the data input/output lines DB and $\overline{DB}$ is amplified. Thus the necessary data are provided at a data output terminal DATA OUT. Then, circuit operations in response to $\overline{CAS}$ have been finished.

Next, if only $\overline{RAS}$ is at the high level while maintaining $\overline{CAS}$ at low level, then at first RAS falls, and subsequently $XP_0$, $XP_1$ and $XP_2$ rise in level to effect reset-precharge operations in the $\overline{RAS}$ system. While AERAS, RA and SE at the low level. At this moment, in response to the rise of $XP_0$, CAS falls and subsequently $YP_0$ and $YP_1$ rise to effect reset-precharge operations in the CAS system while AECAS, RE and DE are at the low level. In other words, even if $\overline{RAS}$ is at the high level (reset state) while maintaining $\overline{CAS}$ at the low level (active state), both the $\overline{RAS}$ system and the $\overline{CAS}$ system are subjected to reset-precharge. Then the latch control circuit 59 shown in Fig. 5 acts upon the output terminal DATA OUT, so that the read-out data are held at the output terminal DATA OUT. This latch function is provided, for example, by the output control circuit illustrated in Fig. 8.

Referring now to Fig. 8, when the $\overline{CAS}$ system is reset, MOST $Q_{81}$ becomes non-conducting and MOST $Q_{82}$ becomes conducting, so that a junction point $N_{13}$ shifts to the ground potential and hence MOSTs $Q_{83}$ and $Q_{84}$ become non-conducting. At junction points $N_{11}$ and $N_{12}$ remains a read-out information level, which is dynamically maintained by their capacitance, and junction points $N_{14}$ and $N_{15}$ are reset to the ground potential on the side of the output amplifier 58. MOSTs $Q_{85}$ to $Q_{90}$ form a control circuit for maintaining the output terminal DATA OUT at a high impedance when $\overline{CAS}$ is at the high level. In this case, $\overline{CAS}$ is held at the low level and MOST $Q_{86}$ is non-conducting. Hence a junction point $N_{16}$ stores an electric charge passed through MOST $Q_{85}$ in response to the high level of RE, and thus the junction point $N_{16}$ is held at the high level. MOST $Q_{88}$ is chosen to have a sufficiently large current capacity with respect to MOST $Q_{87}$ so that a junction point $N_{17}$ may be held at the low level, and MOST $Q_{89}$ and MOST $Q_{90}$ are non-conducting, resulting in no influence upon the levels at the junction points $N_{11}$ and $N_{12}$. By the above description, it has been explained that the read-out data can be maintained at the output terminal DATA OUT. Now, when $\overline{RAS}$ shifts to the low level as its active level while $\overline{CAS}$ is kept at the active level, then RAS, AERAS, RA and SE rise in succession. On the other hand when the charging of the load MOST $Q_{52}$ in the inverter $I_3$ to which $\overline{CAS}$ is applied in response to AERAS has been completed, CAS rises and subsequently AECAS and RE rise in succession, and hence the junction point $N_{13}$ in Fig. 8 rises, resulting in conducting of MOSTs $Q_{83}$ and $Q_{84}$. Thus the junction points $N_{11}$ and $N_{14}$ and the junction points $N_{12}$ and $N_{15}$ are respectively connected to each other and both shift to the ground potential. Accordingly, MOST $Q_{61}$ and MOST $Q_{62}$ become non-conducting so that the output terminal DATA OUT is held at a high impedance. When DE rises subsequently to the rise of RE, the output amplifier circuit 58 is activated, and hence an information in a newly selected memory cell appears at the output terminal DATA OUT. However, since the address input upon this activation is meaningless, the revealed output data cannot be used effectively. Moreover, if the $\overline{WE}$ input is made its active level at this moment, the meaningless input data will be written in the memory, and therefore, the activation of $\overline{WE}$ must be inhibited. Thus the operation is provided such that while the read-out data appearing in response to active level of both $\overline{RAS}$ and $\overline{CAS}$ is maintained at the output terminal, refresh is effected by repeating the active level of RAS as shown in Fig. 4, and this operation is called HIDDEN REFRESH. However, in the presently known HIDDEN REFRESH, it is required to main-

tain the $\overline{WE}$ at inactive level, resulting in the lack of versatility of timing signals.

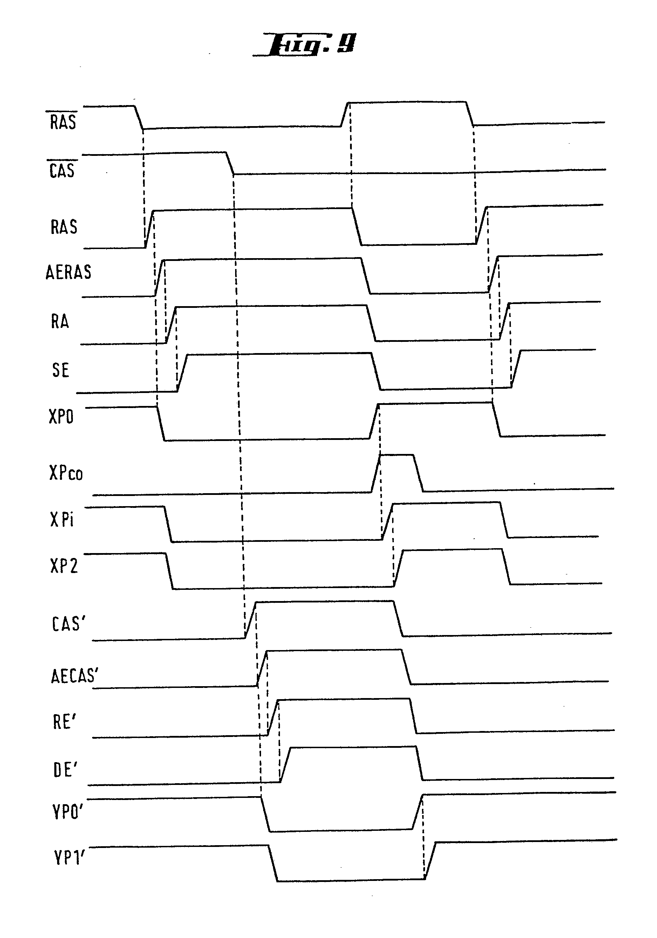

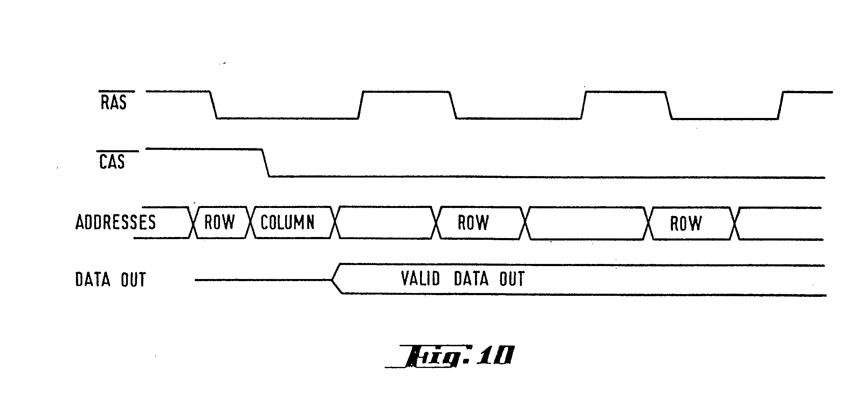

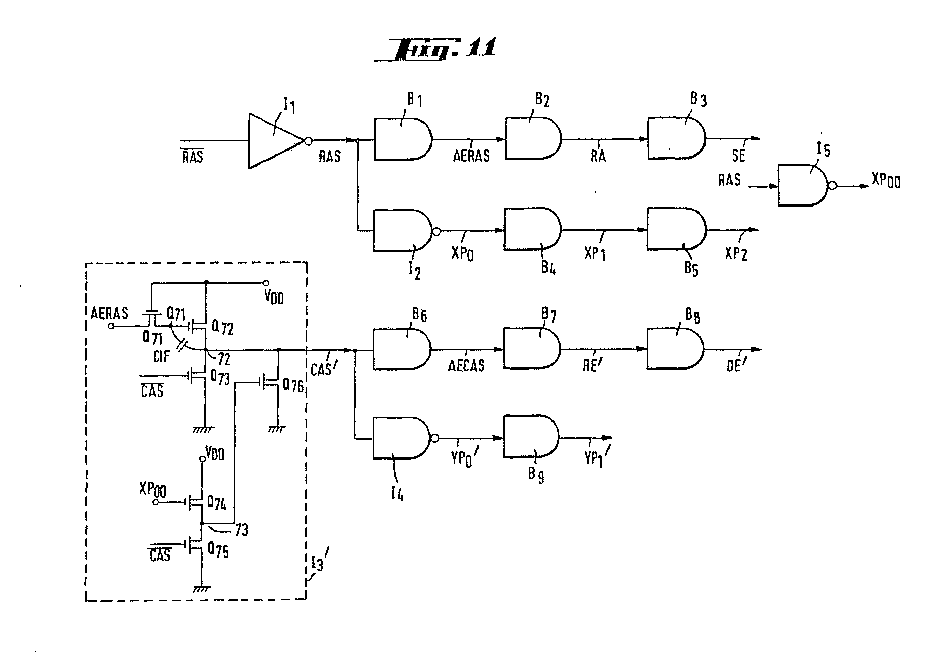

While the circuit system according to the present invention is similar to the prior art circuit system in that where $\overline{RAS}$ is in its reset state while maintaining $\overline{CAS}$ at its active state, both the $\overline{RAS}$ system and the $\overline{CAS}$ system are reset and precharged, the present invention is characterized in that where $\overline{RAS}$ is subsequently made its active level while $\overline{CAS}$ is kept at its inactive level, the $\overline{RAS}$ system circuit can operate but the $\overline{CAS}$ system circuit is kept reset and does not operate, More particularly, although the timing signal CAS derived by inverting the level of $\overline{CAS}$ can be reset when $\overline{RAS}$ is reset while maintaining $\overline{CAS}$ active, upon subsequent activation of $\overline{RAS}$ the rise of the timing signal CAS is suppressed, so that CAS system circuit does not change from the reset state at this time, and all the activation operations therein are inhibited. In this case, the digit line would not be connected to the data input/out line, and moreover, since the $\overline{WE}$ series timing is normally driven by $\overline{CAS}$ series circuit, the $\overline{WE}$ input is not involved in the circuit operation caused by the activation of $\overline{RAS}$ at all. The waveforms of the respective timing signals according to the present invention are illustrated in Fig. 9 in a similar fashion to Fig. 7. The timing signals RAS, AERAS, RA, SE, $SP_0$, $XP_1$, $XP_2$ generated in the $\overline{RAS}$ system timing generator circuit are the same as those in Fig. 7, and the $\overline{RAS}$ system timing generator circuit (see Fig. 11) is also identical to that shown in Fig. 6. However, the $\overline{CAS}$ system timing signals are modified according to the present invention, and they are represented by reference letters CAS', AECAS', RE', DE', $YD_0'$ and $YP_1'$. The $\overline{CAS}$ system timing generator circuit is accordingly modified as shown in Fig. 11. Since the restriction imposed on the $\overline{WE}$ input in the prior art system shown in Fig. 4 is eliminated, HIDDEN REFRESH in the circuit system according to the present invention is effected to irrespective of $\overline{WE}$ as shown in Fig. 10. Furthermore, the circuit system according to the present invention involves an additional advantage that since the activation operations in the $\overline{CAS}$ system circuit are entirely suppressed, the power consumption upon HIDDEN REFRESH can be made as small as that upon RAS ONLY REFRESH illustrated in Fig. 3.

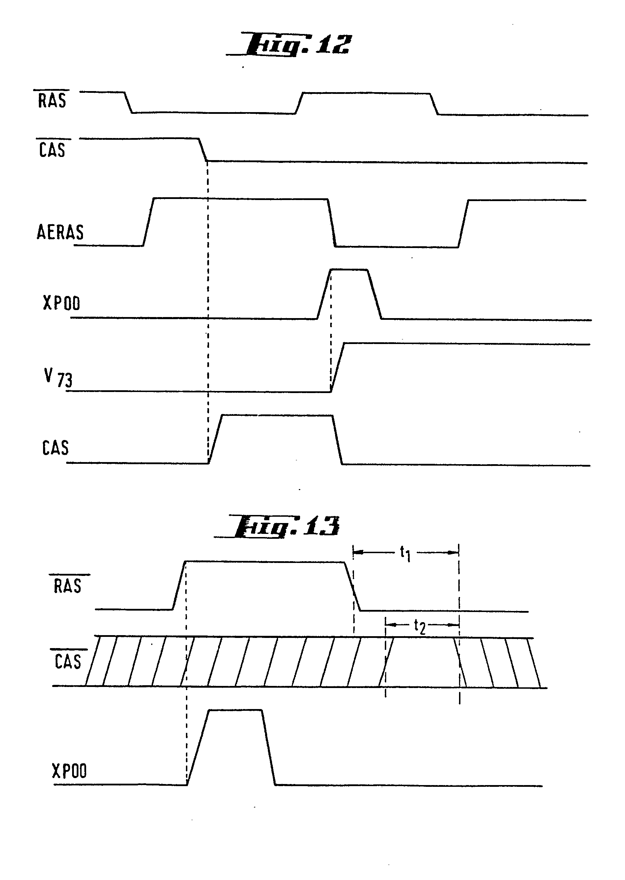

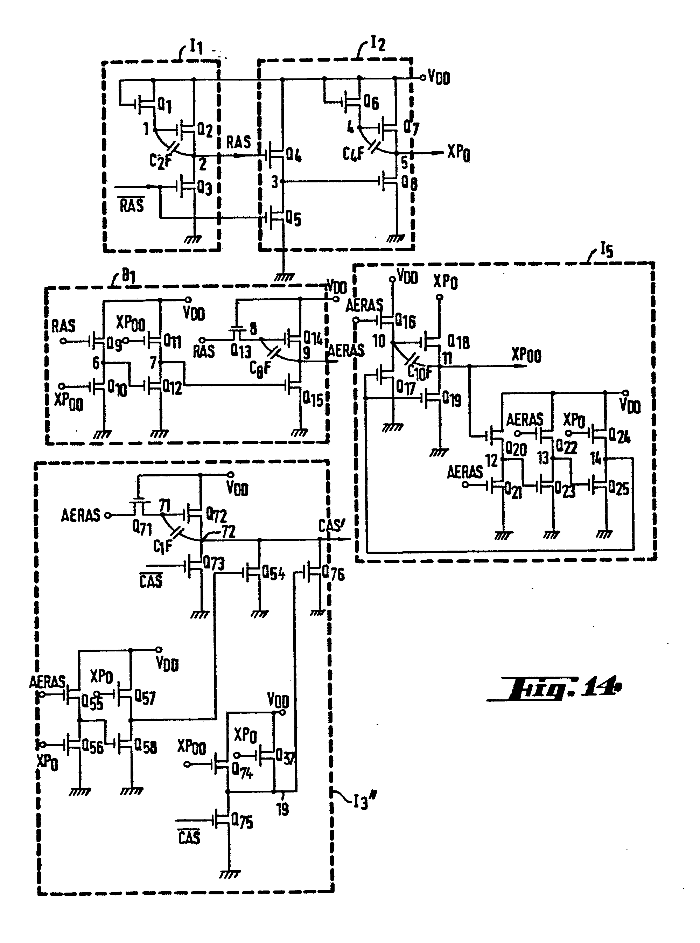

Now description will be made on a practical circuit for realizing the above-described circuit system according to the present invention, with references to Fig. 11 which shows a basic circuit construction of the timing generator circuit and Fig. 12 which illustrates waveforms at principal junction points. As described previously, the activation timing signal CAS' derived by level-inversion of the $\overline{CAS}$ input is normally generated by an inverter $I_3'$ including MOSTs $Q_{71}$, $Q_{72}$ and $Q_{73}$. When $\overline{RAS}$ is turned to the active (low) level and AERAS rises, a junction point 71 is charged through MOST $Q_{71}$. After a

sufficient period of time, $\overline{CAS}$ is turned to the active (low) level to turn MOST $Q_{73}$ to nonconducting, and CAS' begins to rise through MOST $Q_{72}$, which is driven to an unsaturated region owing to the existence of a boot-strap capacitor C1F, and hence CAS' reaches the $V_{DD}$ level. When the activation period of RAS terminates and it goes into a reset period, the clock $XP_{00}$ MOST $Q_{74}$ rises immediately, and after a junction point 73 has been sufficiently charged through MOST $Q_{74}$ it shifts to the low level within the reset period of RAS. Due to the rise of the junction point 73, MOST $Q_{76}$ becomes conducting and CAS' shifts to the ground potential. Assuming that $\overline{CAS}$ is maintained at the low level, MOST $Q_{75}$ is nonconducting, so that the junction point 73 is held at the high level, and after $XP_{00}$ becomes low, the junction point 73 is maintained at the high level by a capacitance at the junction point 73. Subsequently, when $\overline{RAS}$ is made at its active (low) level again while $\overline{CAS}$ is kept at the low level, the timing signal AERAS rises and thereby the junction point 71 is charged. However, if the current capacity of MOST $Q_{76}$ is chosen sufficiently large with respect to that of MOST $Q_{72}$, then CAS' cannot rise because the junction point 73 is kept at the high level. In other words, the requirement that the activation operations in the $\overline{CAS}$ system circuit should be all suppressed, can be fulfilled. In place of the timing $XP_{00}$, $XP_0$ may similarly be used. Under the timing condition of $\overline{RAS}$ and $\overline{CAS}$ in the HIDDEN REFRESH mode, the circuit of MOSTs $Q_{74}$ to $Q_{76}$ can realize the timing condition in Fig. 9 and the operation mode illustrated in Fig. 10, and it can be proved by reference to Fig. 13 that this circuit does not affect any other timing condition of $\overline{CAS}$ during the period from the reset of $\overline{RAS}$ to the next activation of the same. Other timing conditions of $\overline{CAS}$ are limited only to the case where $\overline{CAS}$ is reset, and in this case normally rated limitation to the minimum value is imposed upon time periods $t_1$ and $t_2$ shown in Fig. 13. As will be seen from this, the period when CAS is held at the high level after the shift of $XP_{00}$ to the low level, can be assured at least for the time $t_2$. In the circuit shown in Fig. 11, after $XP_{00}$ has shifted to the low level, MOST $Q_{74}$ is non-conducting, and the junction point 73 becomes to be maintained at the high level in a dynamic fashion. But when $\overline{CAS}$ shifts to the high level and MOST $Q_{75}$ becomes conducting, the junction point 73 is immediately discharged and shifts to the ground potential. When MOST $Q_{76}$ becomes non-conducting as a result of the above, the circuit can respond to next activation of the $\overline{CAS}$ series circuit without affecting CAS. The time $t_2$ necessary for discharging of the junction point 73 is normally assured.

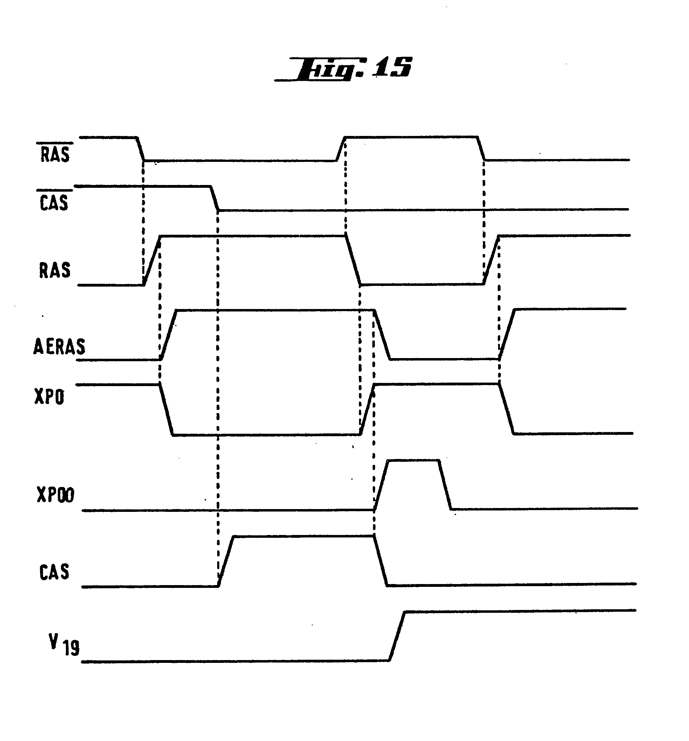

While the operation of the basic timing circuit according to the present invention illustrated in Fig. 11 has been described above, now a practical circuit structure of one preferred embodiment of the present invention will be explained with reference to a circuit diagram shown in Fig. 14 in which major parts of the control timing generator circuits are shown and a waveform diagram showing operation waveforms at principal junction points in the circuit illustrated in Fig. 15. In the circuit shown in Fig. 14, the circuit according to the present invention is applied to the inverter $I_{11}$ to which CAS is input, and a necessary $\overline{RAS}$ system timing signal generator circuit is added to the circuit. The inverter $I_3''$ corresponds to the inverter $I_3'$ of Fig. 11 and other circuit blocks denoted as $I_1$, $I_5$ and $B_1$ correspond to ones denoted by the same references in Fig. 11. The output circuit has such construction as shown in Fig. 8 that in the read cycle, after completion of an access operation, effective data can be maintained at the output terminal so long as $\overline{CAS}$ is not reset. Starting from the state where both $\overline{RAS}$ and $\overline{CAS}$ are reset, if $\overline{RAS}$ is made at the active level at first, then RAS rises up to the $V_{DD}$ level via MOST $Q_2$ owing to the boot-strap capacitor C2F. In response to RAS, a junction point 3 rises up to the level of ($V_{DD}$—threshold voltage), and so, by selecting a current capacity of MOST $Q_8$ sufficiently large with respect to that of MOST $Q_7$, $XP_0$ is shifted from the $V_{DD}$ level to the low level. On the other hand, in response to RAS, a timing signal AERAS rises up to the $V_{DD}$ level, and thereafter activation operations in the $\overline{RAS}$ series circuit are carried out. In response to the rise of AERAS, a junction point 10 is raised via MOST $Q_{16}$ up to the level of ($V_{DD}$—threshold voltage), and as waiting for the later one of $\overline{CAS}$ being activated and a junction point 18 which is an output of a delay circuit responsive to AERAS shifting to the ground potential, that is; after MOSTs $Q_{73}$ and $Q_{54}$ both have become non-conducting, CAS rises. Then CAS reaches the $V_{DD}$ level via MOST $Q_{72}$ owing to a boot-strap capacitor C1F. In response to CAS, activation operations in the $\overline{CAS}$ system circuit are effected, and assuming that the cycle under consideration is a read cycle, effective data appear at the output terminal. Under such a condition, when $\overline{RAS}$ is reset while maintaining $\overline{CAS}$ activated, RAS shifts to the low level and subsequently the junction point 3 shifts to the ground potential. MOST $Q_8$ becomes non-conducting, hence $XP_0$ rises via MOST $Q_7$ and reaches the $V_{DD}$ level owing to a boot-strap capacitor C4F. In response to the rise of $XP_0$, $XP_{00}$ rises via MOST $Q_{18}$, showing a waveform synchronized with $XP_0$, and also reaches the $V_{DD}$ level owing to a boot-strap capacitor C10F. In response to $XP_{00}$, a circuitry consisting of MOSTs $Q_{20}$ to $Q_{25}$ operates, and as a result, when a junction point 14 rises, MOSTs $Q_{17}$ and $Q_{19}$ becomes conducting, resulting in shift of $XP_{00}$ to the ground potential. In other words, $XP_{00}$ is held at the high level equal to $V_{DD}$ during the operation period of the circuitry of MOSTs $Q_{20}$ to $Q_{25}$. During this period, a junction point 19 is charged via MOST $Q_{74}$ up to the level of

($V_{DD}$—threshold voltage). The voltage at the junction point 19 is indicated as $V_{19}$ in Fig. 15. If only MOST $Q_{74}$ were to be used, after $XP_{00}$ has shifted to the ground potential the junction point 19 would take the high level that is dynamically maintained, and if the period of this condition is long, there is a risk that the level may be attenuated. Therefore, as a back-up, MOST $Q_{37}$ having a small current capacity and having $XP_0$ applied to its gate is added between the $V_{DD}$ power source and the junction point 19. Since $\overline{CAS}$ is not reset, effective data are in themselves maintained at the output terminal. Thereafter, if $\overline{RAS}$ is made active level while also keeping $\overline{CAS}$ at the active level, then activation operations in the $\overline{RAS}$ system circuit are effected in a similar manner to the above, and thereby the contents in the memory cells on the word line corresponding to the designated row address at the address input can be refreshed. In response to the rise of AERAS, a junction point 71 rises up to the level of ($V_{DD}$—threshold voltage). However, since the junction point 19 is also maintained at the level of ($V_{DD}$—threshold voltage) and since a current capacity of MOST $Q_{76}$ is sufficiently larger than that of MOST $Q_{72}$, CAS' cannot rise but held at the low level. Accordingly, the activation operations in the $\overline{CAS}$ system circuit are all inhibited, and only refresh operations in response to the RAS input can be effected. So long as the $\overline{CAS}$ input is held at the low level, effective data can be maintained in themselves at the output terminal, even if reset and activation of the $\overline{RAS}$ input are repeated the circuit other than the $\overline{RAS}$ system circuit is held in a reset condition without operating at all, and thus refresh is effected in succession. As a result, HIDDEN REFRESH illustrated in Fig. 10 can be realized.

As described above, according to the present invention there is provided a circuit system characterized by the function that after necessary operations for a selected memory cell have been completed by sequentially making $\overline{RAS}$ and $\overline{CAS}$ at their active levels, $\overline{RAS}$ is reset while $\overline{CAS}$ is kept at its active level, and after a necessary reset period, when $\overline{RAS}$ is again made the active level, all the activation operations responsive to $\overline{CAS}$ are inhibited, whereby the state at the time point when said necessary operations were completed can be in itself maintained at the data output terminal. Furthermore, according to the present invention, the aforementioned function can be realized by adding to an inverter for generating CAS a circuit comprising a first MOST ($Q_{76}$ in Fig. 11), having drain connected to a level-inversion output CAS for the $\overline{CAS}$ input, gate connected to a first junction point (73 in Fig. 11) and source connected to the ground potential, a seemed MOST ($Q_{74}$ in Fig. 11) having drain connected to a power supply terminal ($V_{DD}$ in Fig. 11), gate connected to a one-shot precharge clock ($XP_{00}$ in Fig. 11) from the $\overline{RAS}$ system circuit and source connected to the first junction point, and

a third MOST ($Q_{75}$ in Fig. 11) having drain connected to the first junction point, gate connected to the CAS input and its source connected to the ground potential.

Since many changes could be made in the above circuit arrangement and many apparently widely different embodiments of this invention could be made without departing the scope thereof, it is intended that all matter contained in the above description or shown in the accompanying drawings shall be interpreted as illustrative and not as a limitation to the scope of the invention.

## Claims

1. A memory device comprising a plurality of memory cells arranged at intersections of word lines and digit lines (54, 57), input means for receiving an address signal (Address Input), means for receiving a row strobe signal ($\overline{RAS}$), means for receiving a column strobe signal ($\overline{CAS}$), means for incorporating row address information (50) through said input means in response to presence of said row strobe signal, means for incorporating column address information (53) through said input means in response to presence of said column address strobe signal, word control means (51, 52) for selectively controlling said word lines based on the incorporated row address information, digit control means (55, 56) for selectively deriving logic information from said digit lines based on the incorporated column address information, and timing means (Q71, Q72, Q73) for generating a control signal for enabling said digit control means, said timing means setting said control signal in response to the presence of said column address strobe signal following the presence of said row address strobe signal and resetting said control signal in response to the absence of said row strobe signal following the presence of said column strobe signal and having function of sequentially effecting refresh operations on the different word lines with maintaining read-out data at an output terminal by repeatedly setting said row strobe signal and maintaining said column strobe signal in set state after establishing the read-out data by sequentially setting said row strobe signal and said column strobe signal, characterized in that the memory device comprises suppress means (Q74, Q75, Q76) for suppressing said control signal when said row strobe signal is once reset within a set period of said column strobe signal and maintain such suppression within the set period of said column strobe signal and said digit control means is inhibited from repeating its operation after deriving the read-out data during said refresh function.

2. The memory device according to claim 1, characterized in that said timing means includes a first junction point (72), a first precharge circuit (Q71, Q72) for operatively precharging said first junction point within the set period of said row strobe signal and a first discharge circuit (Q73) for operatively discharging electric charge stored at said first junction point in response to the reset of said column strobe signal.

3. The memory device according to claim 2, characterized in that said suppress means includes a second junction point (73), a second precharge circuit (Q74) for operatively precharging said second junction point within the reset period of said row strobe signal, a second discharge circuit (Q75) for operatively discharging electric charge at said second junction point in response to the reset of said column strobe signal, and a third discharge circuit (Q76) operatively discharging the electric charge at said first junction point in response to the electric charge at said second junction point.

4. The memory device according to claim 2, characterized by further comprising means (15) for generating a one shot timing signal (XP00) for controlling said second precharge circuit, in which said one shot timing signal takes an its active level in response to a transient from the set to the reset of said row strobe signal and changes to its inactive level after predetermined period from said transient within the period of said reset of said row strobe signal.

## Patentansprüche

1. Speicheranordnung mit einer Vielzahl von Spiecherzellen, die an Schnittpunkten von Wortleitungen und Bit-Leitungen (54, 57), angeordnet sind, einer Eingangsvorrichtung zum Empfangen eines Adressensignals (Adresseneingang), einer Vorrichtung zum Empfangen eines Zeilenstrobesignals ($\overline{RAS}$), einer Vorrichtung zum Empfangen eines Spaltenstrobesignals ($\overline{CAS}$), einer Vorrichtung zum Aufnehmen von Spaltenadressinformation (53) über die Eingangsvorrichtung in Abhängigkeit von der Anwesenheit des Spaltenstrobesignals, einer Wortsteuervorrichtung (51, 52) zum selektiven Steuern der Wortleitungen auf der Basis der aufgenommenen Zeilenadressinformation, einer Bitsteuervorrichtung (55, 56) zum selektiven Ableiten logischer Information von den Bit-Leitungen auf der Basis der aufgenommenen Spaltenadressinformation, und einer Synchronisationsvorrichtung (Q71, Q72, Q73), zum Erzeugen eines Steuersignals zum Aktivieren der Bitsteuervorrichtung, wobei die Spaltenadresstrobesignals in Folge der Anwesenheit des Zeilenadresstrobesignals und Spaltenaddresstrobesignals in Folge der Anwesenheit des Zeilenaddresstrobesignals und das Steuersignal zurücksetzt in Abhängigkeit von der Abwesenheit des Zeilenadresstrobesignals in Folge der Anwesenheit des Spaltenadresstrobesignals, und wobei die Synchronisationsvorrichtung sequentiell eine Auffrischfunktion auf die verschiedenen Wortleitungen ausübt und dabei die Auslesedaten an einer Ausgangsklemme beibehält durch wiederholtes Setzen des Zeilenstrobesignals und das Spaltenstrobesignal nach dem Herstellen der Auslesedaten in gesetztem Zustand erhält durch sequentielles Setzen des Zeilenstrobesignals und des Spaltenstrobesignals, dadurch gekennzeichnet, daß die Speicheranordnung eine Unterdrückervorrichtung (Q74, Q75, Q76) aufweist zum Unterdrücken des Steuersignals, wenn das Zeilenstrobesignal einmal innerhalb einer Setzperiode des Spaltenstrobesignals zurückgesetzt wurde und zum Beibehalten der Unterdrückung während der Setzperiode des Spaltenstrobesignals und daß die Bitsteuervorrichtung am Wiederholen ihres Betriebs gehindert wird nach dem Ableiten der Auslesedaten während des Auffrischbetriebes.

2. Speicheranordnung nach Anspruch 1, dadurch gekennzeichnet, daß die Synchronisationsvorrichtung einen ersten Verbindungspunkt (72), eine erste Vor-Lade-Schaltung (Q71, Q72) zum Vorladen des ersten Verbindungspunktes im Betrieb während der Setzperiode des Zeilenstrobesignals und eine erste Entlade-schaltung (Q73) aufweist, zum Abführen elektrischer Ladung in Betrieb, die in Abhängigkeit von Zurücksetzen des Spaltenstrobesignals am ersten Verbindungpunkt gespeichert wurde.

3. Speicheranordnung nach Anspruch 1 und 2, dadurch gekennzeichnet, daß die Unterdrückervorrichtung eine zweiten Verbindungspunkt (73) aufweist, eine zweite Vor-Lade-Schaltung (Q74) zum Vorladen des zweiten Verbindungspunktes im Betrieb während der Rücksetzperiode des Zeilenstrobesignals, eine zweite Entlade-schaltung (Q75) zum Abführen elektrischer Ladung im Betrieb, die im zweiten Verbindungspunkt in Abhängigkeit vom Rücksetzen des Spaltenstrobesignals gespeichert wurde, und eine dritte Entlade-schaltung (Q76), die im Betrieb in Abhängigkeit von der elektrischen Ladung am zweiten Verbindungspunkt die elektrische Ladung am ersten Verbindungspunkt ableitet.

4. Speicheranordnung nach Anspruch 2, dadurch gekennzeichnet, daß sie ferner eine Vorrichtung (15) aufweist zum Erzeugen eines Einmal-synchronisationssignals (XP00) zum Steuern der zweiten Vor-Lade-Schaltung, wobei das Einmalsynchronsignal seinen aktiven Pegel annimmt in Abhängigkeit vom Übergang von Setzen zu Rücksetzen des Zeilenstrobesignals, und zu seinem inaktiven Pegel wechselt nach einer vorbestimmten Zeit nach diesem Übergang innerhalb der Rücksetzperiode des Zeilenstrobesignals.

**Revendications**

1. Dispositif à mémoire comprenant une pluralité de cellules de mémoire disposées aux intersections de lignes de mots et de lignes de chiffres (54, 57), un moyen d'entrée pour recevoir un signal d'adresse (Entrée d'adresse), un moyen pour recevoir un signal d'échantillon de rangée (RAS), un moyen pour recevoir un signal d'échantillon de colonne (CAS), un moyen pour incorporer une information (50) sur les adresses de rangée par l'intermédiaire du moyen d'entrée en réponse à la présence du signal d'échantillon de rangée, un moyen pour incorporer une information (53) sur les adresses de colonne par l'intermédiaire du moyen d'entrée en réponse à la présence du signal d'échantillon d'adresse de colonne, un moyen de commande de mots (51, 52) pour sélectivement commander les lignes de mot sur la base de l'information incorporée sur les adresses de rangée, un moyen de commande de chiffre (55, 56) pour obtenir sélectivement une information logique à partir des lignes de chiffres sur la base de l'information incorporée sur les adresses de colonne, et un moyen de synchronisation (Q71, Q72, Q73) pour produire un signal de commande afin de valider le moyen de commande de chiffre, ce moyen de synchronisation chargeant le signal de commande en réponse à la présence du signal d'échantillon d'adresse de colonne suivant la présence du signal d'échantillon d'adresse de rangée et procédant à la remise à l'état initial du signal de commande en réponse à l'absence du signal d'échantillon de rangée suivant la présence du signal d'échantillon de colonne et ayant la fonction d'effectuer séquentiellement des opérations de régénération sur les différentes lignes de mots tout en maintenant la donnée de lecture à une borne de sortie en remettant de manière répétée à l'état initial le signal d'échantillon de rangée et en maintenant le signal d'échantillon de colonne à l'état chargé après établissement de la donnée de lecture par chargement séquentiel du signal d'échantillon de rangée et du signal d'échantillon de colonne, caractérisé en ce que le dispositif à mémoire comprend des moyens de suppression ($Q_{74}$, $Q_{75}$, $Q_{76}$) pour supprimer le signal de commande lorsque le signal d'échantillon de rangée est remis une fois à l'état initial pendant une période établie du signal d'échantillon de colonne et pour maintenir une telle suppression pendant la période établie du signal d'échantillon de colonne, et le moyen de commande de chiffre est empêché de répéter son fonctionnement après obtention de la donnée de lecture pendant la fonction de régénération.

2. Dispositif à mémoire selon la revendication 1, caractérisé en ce que le moyen de synchronisation comprend un premier point de jonction (72), un premier circuit de pré-charge ($Q_{71}$, $Q_{72}$) pour pré-charger le premier point de jonction pendant la période établie du signal d'échantillon de rangée, et un premier circuit de décharge ($Q_{73}$) pour décharger la charge électrique stockée au premier point de jonction en réponse à la remise à l'état initial du signal d'échantillon de colonne.

3. Dispositif à mémoire selon la revendication 2, caractérisé en ce que le moyen de suppression comprend un second point de jonction (73), un second circuit de pré-charge (Q$_{74}$) pour pré-charger le second point de jonction à l'intérieur de lapériode de remise à l'état initial du signal d'échantillon de rangée, un second circuit de décharge (Q$_{75}$) pour décharger la charge électrique au second point de jonction en réponse à la remise à l'état initial du signal d'échantillon de colonne, et un troisième circuit de décharge (Q$_{76}$) pour décharger la charge électrique au premier point de jonction en réponse à la charge électrique au second point de jonction.

4. Dispositif à mémoire selon la revendication 2, caractérisé en ce qu'il comprend en outre un moyen (15) pour produire un signal de synchronisation monostable (XP$_{00}$) pour commander le second circuit de précharge, dans lequel le signal de synchronisation monostable prend son niveau actif en réponse à un passage transitoire entre la charge et la remise à l'état initial du signal d'échantillon de rangée et prend son niveau inactif après une période prédéterminée à partir du passage transitoire au cours de la période de remise à l'état initial du signal d'échantillon de rangée.

**Fig. 1** (prior art)

**(A) Read Cycle**

$\overline{RAS}$

$\overline{CAS}$

$\overline{WE}$

ADDRESSES — ROW — COLUMN

DATA OUT — Hi-z — Valid Data

**(B) Write Cycle**

$\overline{RAS}$

$\overline{CAS}$

$\overline{WE}$

ADDRESSES — ROW — COLUMN

DATA OUT — Hi-z

DATA IN

*Fig. 2* (prior art)

*Fig. 3* (prior art)

0 017 228

RAS

CAS

ADDRESSES ╳ ROW ╳ COLUMN ╳ ROW ╳ ROW ╳

WE

DATA OUT      Valid Data

*Fig. 4* (prior art)

**Fig. 5**

Memory Cell 54 — Column Decoder 55 (DB) — Sense Amp. — Column Decoder 55' (DB̄) 56 — Memory Cell 57

Row Address Inverter 50 — Row Decoder 51 (RA) — Row Decoder 52 (RA) — Column Address Inverter 53

RE, SE, RE

AERAS, AECAS

Address Input

Output Amp 58 (DE) — Latch Cnt. 58

Q 61 (Vcc) — Q 62 — DATA OUT

CNT 60 — RAS, CAS — AERAS, RA, RE, SE, AECAS, DE

4

_Fig. 6_ (prior art)

## Fig. 7 (prior art)

Fig. 8

# Fig. 9

*Fig. 10*

0 017 228

Fig. 11

## Fig. 12

RAS

CAS

AERAS

XP00

V 73

CAS

## Fig. 13

RAS

CAS

XP00

$t_1$

$t_2$

*Fig. 14*

## Fig. 15